# EUROPÄISCHE PATENTSCHRIFT

(11) **EP 2 859 374 B1**
(45) Veröffentlichungstag und Bekanntmachung des Hinweises auf die Patenterteilung: **13.06.2018**
(21) Anmeldenummer: 13717045.2
(22) Anmeldetag: 18.04.2013
(51) Int. Cl.: G01R 35/00, G01R 31/02, G01R 21/133, G01R 35/04

(54) **VORRICHTUNG ZUM KALIBRIEREN EINES LEISTUNGSMESSSYSTEMS FÜR LEISTUNGSTRANSFORMATOREN**
APPARATUS FOR CALIBRATING A POWER MEASURING SYSTEM FOR POWER TRANSFORMERS
DISPOSITIF POUR CALIBRER UN SYSTÈME DE MESURE DE PUISSANCE POUR DES TRANSFORMATEURS DE PUISSANCE

(30) Priorität: 12.06.2012 DE 102012105045
(43) Veröffentlichungstag der Anmeldung: 15.04.2015
(73) Patentinhaber: Maschinenfabrik Reinhausen GmbH, 93059 Regensburg (DE)
(72) Erfinder: STEINER, Thomas, 01445 Radebeul (DE); KOWAL, Catrina, 01099 Dresden (DE); AUGAT,Sebastian, 03130 Spremberg (DE); THIEDE, Andreas, 01465 Schönborn/ Langebrück (DE)
(86) Internationale Anmeldenummer: PCT/EP2013/058104
(87) Internationale Veröffentlichungsnummer: WO 2013/185958

(56) Entgegenhaltungen:
- WO-A1-97/15806
- DE-A1- 10 048 962
- US-A- 4 795 969
- US-A1- 2004 036 464
- US-A1- 2010 188 240
- DATABASE WPI Week 201164 Thomson Scientific, London, GB; AN 2011-L60490 XP002699353, -& CN 102 156 274 A (SICHUAN ELECTRIC POWER RES INST) 17. August 2011 (2011-08-17)

## Beschreibung

Die vorliegende Erfindung betrifft eine Vorrichtung zum Kalibrieren eines Leistungsmesssystems für Leistungstransformatoren.

Beim Einsatz von Leistungstransformatoren im Energieversorgungsnetz ist die Minimierung der Verlustleistung ein äußerst wichtiges Kriterium. Die Verlustleistung, die sich beispielsweise in Leerlauf- oder Kurzschlussverlusten wiederspiegelt, ist eine design- und/oder fertigungsabhängige Größe und wird deshalb in einer sogenannten Verlustleistungsmessung bei der Routine- und Typprüfung von Leistungstransformatoren nach IEC Standard 60076-1 bzw. IEEE Standard C57.12.90-1999 überprüft. Die Größe der Verlustleistung wirkt sich beim Energieversorger direkt in Kosten aus und wird daher beim Kauf des Leistungstransformators gegenüber dem Hersteller monetär pönalisiert. Aus diesem Grund ist die Verlustleistung beim Kauf eines Leistungstransformators möglichst genau zu ermitteln. Jedes Hochspannungsprüflabor für Leistungstransformatoren verfügt aus diesem Grund über ein sogenanntes Leistungsmesssystem, welches kalibriert sein muss, um mittels des Leistungsmesssystems die Verlustleistung des Leistungstransformators zu bestimmen und möglichst genau zu messen. Die Kalibrierung eines derartigen Leistungsmesssystems ist zudem vorgeschrieben im IEC Standard 60060-2. Relevanter Stand der Technik findet sich in den Dokumenten WO97/15806, CN102156274 sowie US4795969. Derartige aus dem Stand der Technik bekannte Leistungsmesssysteme umfassen als Teilkomponenten eine Strom- und Spannungsquelle, einen Spannungswandler, einen Stromwandler, ein Prüfobjekt, nämlich den Leistungstransformator, und ein Auswertegerät. Um hinreichend genaue Messwerte mit dem Leistungsmesssystem zu gewährleisten, müssen insbesondere der Stromwandler, der Spannungswandler und das Auswertegerät kalibriert werden. Gängige Praxis ist es dabei, diese genannten Teilkomponenten des Leistungsmesssystems, also den Stromwandler, den Spannungswandler und das Auswertegerät, einer zeit- und kostenaufwändigen komponentenspezifischen Einzelkalibrierung zu unterziehen. Dafür müssen die Teilkomponenten Stromwandler, Spannungswandler und Auswertegerät aus dem Leistungsmesssystem ausgebaut und an den entsprechenden Gerätehersteller geschickt werden, damit dieser seine jeweilige Teilkomponente kalibrieren kann. Nachdem dann die Teilkomponente einer Einzelkalibrierung unterzogen wurden, kann das Leistungsmesssystem wieder komplettiert, d.h. zusammengebaut, werden. Die Messunsicherheit des gesamten Leistungsmesssystems wird in einem anschließenden Schritt rechnerisch aus den Messunsicherheiten der vom Hersteller kalibrierten einzelnen Teilkomponenten für das gesamte Leistungsmesssystem errechnet bzw. rückgeschlossen.

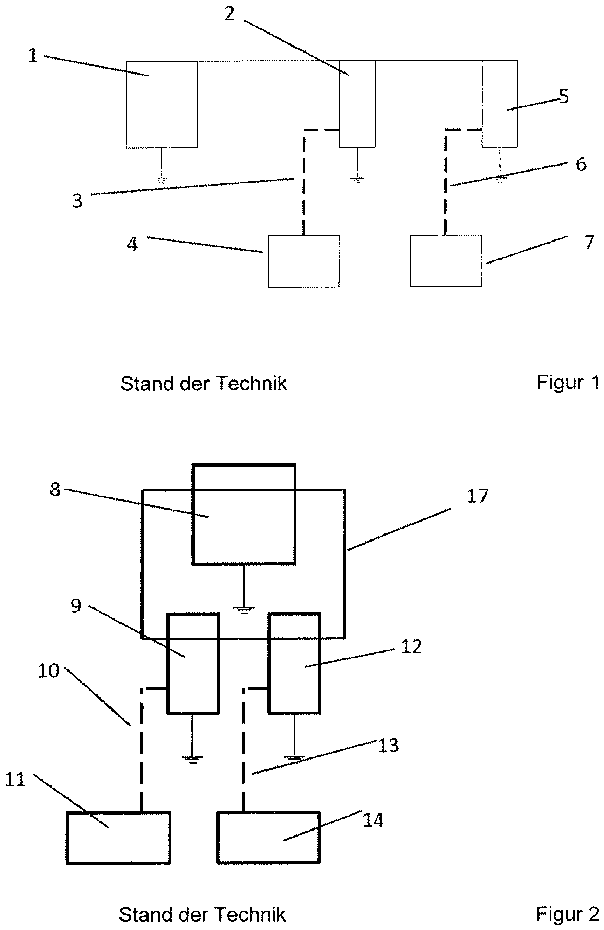

Für die Einzelkalibrierung der Teilkomponenten des Leistungsmesssystems bedient sich der Stand der Technik eines sogenannten Referenzmesssystems. In einem Referenzmesssystem sind die zu ermittelnden, bzw. zu kalibrierenden, elektrischen Kenngrößen auf für den Betreiber bekannte Werte, die die Referenzwerte darstellen, genormt. Das Referenzmesssystem dient also mit anderen Worten als Bezugssystem mit für den Betreiber bekannten elektrischen Ausgabewerten bei festgelegten Eingabewerten. In FIG. 1 ist der Schaltungsaufbau eines aus dem Stand der Technik bekannten Referenzmesssystems zum Kalibrieren der Teilkomponente des Spannungswandlers dargestellt. Das Referenzmesssystem weist hierfür einen Hochspannungstransformator 1 als Spannungsquelle auf, der mittels Anschlussleitungen mit einem Referenzspannungswandler 2 elektrisch in Verbindung steht. Der Referenzspannungswandler 2 wiederum ist mittels eines Messkabels 3 mit einem Referenzauswertegerät 4 elektrisch verbunden. Weiterhin wird von dem Hochspannungstransformator 1 auch das eigentliche Kalibierobjekt, nämlich ein Spannungswandler 5 und ein Auswertegerät 7, das in elektrisch symmetrischer Anordnung zu dem Referenzspannungswandler 2 und dem Referenzauswertegerät 4 an dem Hochspannungstransformator 1 angeordnet ist, elektrisch gespeist.

FIG. 2 zeigt den Schaltungsaufbau eines weiteren, aus dem Stand der bekannten, Referenzmesssystems zur Kalibrierung eines Stromwandlers. Hierfür ist ein Hochstromtransformator 8 als Stromquelle vorgesehen, der mittels eines Hochstromkreises mit einem Referenzstromwandler 9 elektrisch verbunden ist und an dem seinerseits wiederum über ein Referenzmesskabel 10 ein Referenzauswertegerät 11 angeschlossen ist. In dazu symmetrischem Aufbau sind an dem Hochstromkreis des Hochstromtransformators 8 auch die eigentlich zu kalibrierenden Teilkomponenten, nämlich der Stromwandler 12, der über ein Messkabels 13 mit dem Auswertegerät 14 verbunden ist, angeschlossen.

In beiden in den FIG. 1 und 2 dargestellten Referenzmesssystemen wird ein Soll-IstwertAbgleich zwischen den ermittelten physikalischen Größen bzw. deren Werten des Referenzmesssystems im Vergleich zu den einzelnen Teilkomponenten, die zu kalibrieren sind, vollzogen. In dem Referenzmesssystem der FIG. 1 also beispielsweise ein Abgleich der in dem Referenzspannungswandler 2 und Referenzauswertegerät 4 ermittelten Werte mit denen des Kalibrierobjekts, also dem Spannungswandler 5 und dem Auswertegerät 7 -jeweils einschließlich unter Berücksichtigung deren entsprechenden Messkabel 3 und 6.

Insgesamt betrachtet ist der aus dem Stand der Technik bekannte Aufbau der Referenzsysteme zur Kalibrierung der einzelnen Teilkomponenten damit sehr umständlich. Einerseits sind technisch unterschiedliche Referenzmesssysteme notwendig, andererseits müssen Stromwandler und Spannungswandler als Einzelkomponente zum jeweiligen Hersteller um kalibrieren versendet werden.

Aufgabe der vorliegenden Erfindung ist es daher, eine Vorrichtung zum Kalibrieren eines Leistungsmesssystems für Leistungstransformatoren anzugeben, die es entbehrlich macht, unterschiedliche Referenzmesssysteme für die Kalibrierung der Teilkomponenten Stromwandler, Spannungswandler und Auswertegerät des Leistungsmesssystems heranzuziehen und die auf ein Versenden der Teilkomponenten zum Hersteller für deren Einzelkalibrierung verzichtet.

Diese Aufgabe wird durch den Gegenstand des unabhängigen Anspruchs gelöst. Die Untersprüche betreffen besonders vorteilhafte Weiterbildungen der Erfindung.

Die allgemeine erfinderische Idee besteht darin, die beiden aus dem Stand der Technik bekannten Referenzmesssysteme für die Kalibrierung eines Stromwandlers, eines Spannungswandlers und eines Auswertegerätes in einer erfindungsgemäßen, gemeinsamen Vorrichtung zum Kalibrieren eines Leistungsmesssystems für Leistungstransformatoren zu integrieren, die zudem auf einem Container angeordnet ist, derart, dass die Vorrichtung mittels eines Trailers, der den Container aufnimmt, verfahrbar für eine Vor-Ort-Kalibrierung des Leistungsmesssystems von Leistungstransformatoren ausgebildet ist. Der mobile Container verfügt damit erfindungsgemäß über eine komplett vorinstallierte Vorrichtung zum Kalibrieren eines Leistungsmesssystems. Die in dem Container installierte erfindungsgemäße Vorrichtung ermöglicht eine Kalibrierung des gesamten Leistungsmesssystem als Systemkalibrierung, bei der die Genauigkeit der Kalibrierung der Einzelkomponenten, aber auch der Einfluss der Zuleitungen zwischen den Einzelkomponenten sowie der Auswertealgorithmus des Auswertegerätes untersucht bzw. kalibriert werden kann. Damit wird eine höhere Kalibriergenauigkeit im Vergleich zur Kalibrierung der Einzelkomponenten erzielt.

Die einzelnen Teilkomponenten der erfindungsgemäßen Vorrichtung müssen auch nicht speziell für die Kalibrierung des Leistungsmesssystems vorbereitet werden, sondern es ist das zu kalibrierende Leistungsmesssystem lediglich an die erfindungsgemäße Vorrichtung anzuschließen. Somit müssen die zu kalibrierenden Teilkomponenten des Leistungsmesssystems, nämlich der Stromwandler, der Spannungswandler und das Auswertegerät, auch nur mehr mit einer gemeinsamen erfindungsgemäßen Vorrichtung kalibriert werden. Der Stromwandler und Spannungswandler müssen nicht mehr, wie im Stand der Technik, einer Einzelkalibrierung durch den jeweiligen Hersteller unterzogen werden, sondern können gemeinsam Vor-Ort mit nur einer einzigen erfindungsgemäßen Vorrichtung in einem zeitgleich ablaufenden Kalibriervorgang kalibriert werden. Bisher war eine Vor-Ort-Kalibrierung mittels der aus dem Stand der Technik separaten Kalibriersysteme nicht wirtschaftlich vertretbar, da sie jeweils auf einem eigenen Container samt Trailer hätten installiert werden müssen. Es wären also zwei Container, inklusive Trailer samt Zugmaschinen notwendig gewesen, um eine Kalibrierung der Teilkomponenten durchführen zu können. Erst die Integration der beiden bisher im Stand der Technik separaten Referenzmesssysteme zu einer erfindungsgemäßen, gemeinsamen Vorrichtung, die auf einem Container angeordnet wird, macht die Vor-Ort Kalibrierung eines Leistungsmesssystems zu einer wirtschaftlich rentablen Alternative für einen Prüffeldbetreiber. Auch wäre es bisher technisch nicht möglich gewesen, die separaten Kalibriersysteme in der im Stand der Technik bekannten Bauform einfach auf einen einzigen, gemeinsamen Container zu installieren, da hier die notwendigen dielektrischen Abstände zwischen den jeweiligen Systemkomponenten des entsprechenden Kalibriersystems nicht ausreichend sichergestellt gewesen wäre. Dies ist nun erstmalig mittels der erfindungsgemäßen Vorrichtung möglich.

Zudem hat sich gezeigt, dass die erfindungsgemäße Vorrichtung eine gegenüber dem Stand der Technik deutlich genauere Bestimmung der Verlustleistung des Leistungstransformators sichergestellt, da die bisher rechnerische Ermittlung der Messungenauigkeit aus den Messungenauigkeiten der Teilkomponenten entfällt. Dies deshalb, weil erkannt wurde, dass insbesondere die Messleitungen zwischen den Strom- bzw. Spannungswandlern und dem entsprechenden Ausgabegerät, sowie der Auswertealgorithmus im Auswertegerät selbst, der den Phasenwinkel zwischen den gemessenen elektrischen Größen feststellt und aus den Größen Strom, Spannung und Phasenwinkel die Leistung ermittelt, Einfluss auf das Messergebnis innerhalb des Leistungsmesssystems bzw. des Referenzmesssystems während der Kalibrierung der Teilkomponenten haben. Die erfindungsgemäße Vorrichtung erzielt damit eine gegenüber der Einzelkalibrierung der Teilkomponenten des Leistungsmesssystems mittels der bekannten separaten Referenzmesssysteme, und eine sich daran anschließende Hochrechnung des Messfehlers auf das gesamte Leistungsmesssystem, deutlich erhöhte Messgenauigkeit. Häufig wurden auch die Messdaten der Teilkomponenten manuell erfasst und in einem Kalibrierprotokoll für das gesamte Leistungsmesssystem zusammengeführt; der Messfehler der Teilkomponenten wurde damit in das Kalibrierprotokoll des gesamten Leistungsmesssystems übertragen, was letzten Endes auf Kosten der Messwertgenauigkeit des Leistungsmesssystems geschieht.

Die Erfindung wird nachfolgend an Hand von Ausführungsbeispielen unter Verwendung der beschriebenen Zeichnungen noch näher erläutert. Es zeigen:
- FIG. 1: den Schaltplan eines Referenzmesssystem nach dem Stand der Technik zum Kalibrieren eines Spannungswandlers
- FIG. 2: den Schaltplan eines Referenzmesssystem nach dem Stand der Technik zum Kalibrieren eines Stromwandlers
- FIG. 3: den schematisierten Schaltplan einer ersten Ausführungsform einer erfindungsgemäßen Vorrichtung zum Kalibrieren eines Leistungsmesssystems eines Leistungstransformators
- FIG. 4: den schematisierten Schaltplan einer weiteren Ausführungsform einer erfindungsgemäßen Vorrichtung zum Kalibrieren eines Leistungsmesssystems eines Leistungstransformators.

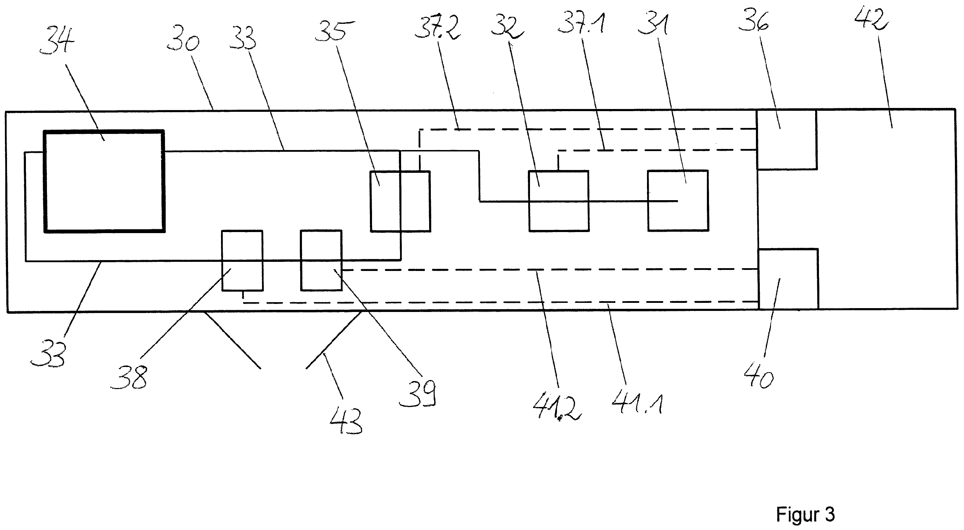

In FIG. 3 ist der schematisierte Schaltplan einer ersten Ausführungsform einer erfindungsgemäßen Vorrichtung zum Kalibrieren eines Leistungsmesssystems eines Leistungstransformators in einer Draufsicht auf einen Container 30 gezeigt. Bei dem Container 30 kann es sich beispielsweise um einen gängigen 40-Fuß Standardcontainer handeln, der mit einem Trailer samt Zugmaschine kompatibel und damit verfahrbar ist. Als Spannungsquelle dient ein im hinteren Bereich des Containers 30 angeordneter Hochspannungstransformator 31, der die erforderliche Prüfspannung von bis zu 100 kV für die erfindungsgemäße Vorrichtung zur Verfügung stellt. Mittels einer elektrischen Leitung steht ein Referenzspannungswandler 32 mit dem Hochspannungstransformator 31 in Verbindung. Der Referenzspannungswandler 32, der eine Eingangsspannung auf für den Prüffeldbetreiber bekannte Ausgangsspannung wandelt, ist seinerseits sowohl über eine Hochstromkreis 33 mit einem Hochstromtransformator 34, der einen maximalen Prüfstrom von 2 kA zur Verfügung stellt, elektrisch verbunden, als auch mit einem Referenzstromwandler 35, der seinerseits wiederum einen Eingangsstrom auf für den Prüffeldbetreiber bekannten Ausgangsstrom wandelt. Darüber hinaus steht ein Referenzauswertegerät 36 jeweils über Referenzmesskabel 37.1 und 37.2 sowohl mit dem Referenzspannungswandler 32 als auch dem Referenzstromwandler 35 elektrisch in Verbindung. Das ebenfalls auf für den Betreiber auf bekannte elektrische Kenngrößen genormte Referenzauswertegerät 36 nimmt bei der Leistungsmessung die Signale des Referenzstromwandlers 32 und Referenzspannungswandlers 35 auf und errechnet daraus die Wirkleistung P, die Scheinleistung S, die Frequenz f, und den Phasenwinkel ⊐ zwischen angelegtem Strom und angelegter Spannung. Zusätzlich kann mittels des Referenzauswertegerätes 36 der Oberwellengehalt der Sinusgrößen ausgewertet werden. Ein sehr weit verbreitetes Referenzauswertegerät 36 für die Leistungsmessung ist das YOKOGAWA WT3000. In den Hochstromkreis 33 eingeschleift sind bei der erfindungsgemäßen Vorrichtung auch die zu kalibrierenden Teilkomponenten des Leistungsmesssystems, nämlich ein Spannungswandler 38, ein Stromwandler 39 und ein Auswertegerät 40. In analog symmetrischen Aufbau zu den Referenzmessgeräten steht auch das Auswertegerät 40 jeweils über Messkabel 41.1 und 41.2 sowohl mit dem Spannungswandler 38 als auch dem Stromwandler 39 elektrisch in Verbindung. Das Referenzauswertegerät 36 sowie das zu kalibrierende Auswertegerät 40 befinden sich dabei in einem elektromagnetisch abgeschirmten Bedienraum 42 innerhalb des Containers 30 angeordnet, um die Messgenauigkeit der erfindungsgemäßen Vorrichtung gewährleistet ist. Der Spannungswandler 38 und der Stromwandler 39 lassen sich dabei auf besonders einfache Weise mittels einer in der Seitenwandung des Containers 30 vorgesehenen, vorzugsweise doppelflügelig ausgebildeten, Türe 43 innerhalb des Containers 30 positionieren. Zudem hat sich gezeigt, dass durch die Platzierung aller Systemkomponenten innerhalb des Containers 30 eine weitere Verbesserung der Messgenauigkeit der erfindungsgemäßen Vorrichtung erreicht wird, da durch eine Klimatisierung des Containers 30 für alle verbauten Systemkomponenten die gleichen klimatischen Bedingungen vorherrschen.

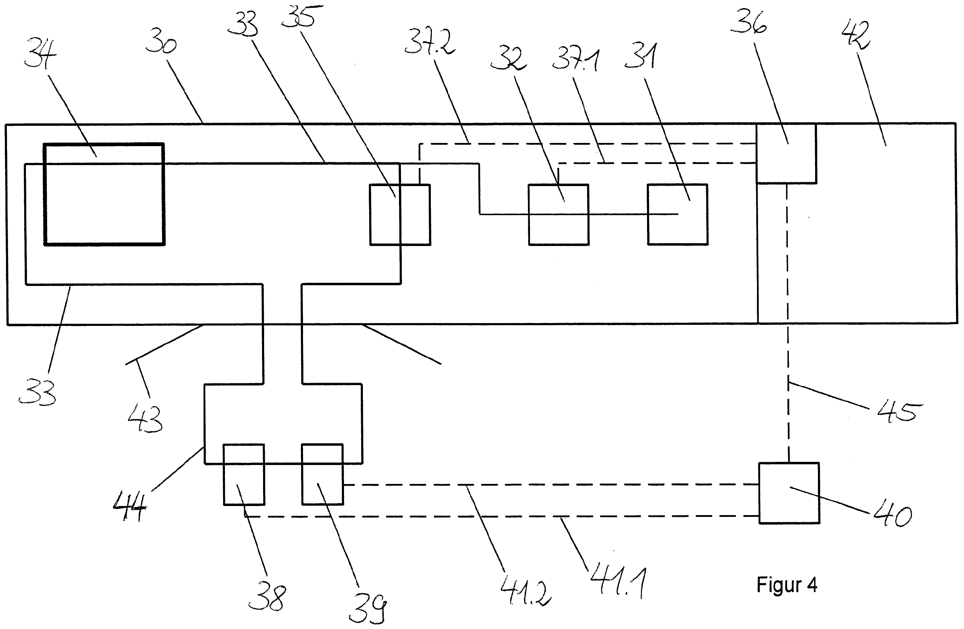

Im Unterschied zu FIG. 3 sind in FIG. 4 der Spannungswandler 38 und der Stromwandler 39 mittels einer verlängerbaren Hochstromverbindung 44 außerhalb des Containers 30 positionierbar. Auch bei dieser Ausführungsform steht das ebenfalls außerhalb des Containers 30 angeordnete Auswertegerät 40 jeweils über Messkabel 41.1 und 41.2 sowohl mit dem Spannungswandler 38 als auch dem Stromwandler 39 elektrisch in Verbindung. Die Kommunikation zwischen dem Referenzauswertegerät 36 und dem zu kalibrierenden Auswertegerät 40 erfolgt hier mittels einer Datenverbindungsleitung 45, beispielsweise in Form einer Remote Control Verbindung.

Aus dem Buch "Hochspannungstechnik" von Andreas Küchler, Springer Verlag, 2005 sind Strom- und Spannungswandler bekannt, wie sie im Rahmen der vorliegenden Erfindung Verwendung finden können. Für die Bestimmung der Spannung haben sich insbesondere kapazitive Spannungswandler im Stand der Technik bewährt wohingegen sich für die Bestimmung des Stroms induktive Stromwandler eignen.

Ein solcher aus dem Stand der Technik bekannter kapazitiver Spannungswandlers wird stets an einem stromdurchflossenen Leiter angeschlossen. Genauer gesagt, werden an einen stromdurchflossenen Leiter zwei in Reihe geschaltete Kondensatoren angeschlossen. Der Niederspannungskondensator in einem unteren Gehäuse wird dabei mit dem Erdpotential verbunden. Ein Oberspannungskondensator ist in einem separaten, isolierenden Stützrohr angeordnet und trennt das Hochspannungspotential am oberen Gehäuse vom Erdpotential des unteren Gehäuses. Das obere Gehäuse, welches die Verbindung zwischen dem Leiter und dem Oberspannungskondensator umgibt, liegt ebenfalls auf Hochspannungspotential. Aus dem Verhältnis der beiden Kondensatoren sowie der gemessenen Spannung am Niederspannungskondensator lässt sich die Spannung am stromdurchflossenen Leiter ermitteln.

Für die Bestimmung des Stromes werden meist induktive Stromwandler verwendet. Dabei ist um den stromdurchflossenen Leiter ein geschlossener, ringförmiger Eisenkern angeordnet, um den eine Wicklung gewickelt ist, in der ein Strom induziert wird, sobald ein Strom durch den Leiter fließt. Ein Nebenschlusswiderstand ist mit der Wicklung in Reihe geschaltet. Durch Messung des Stromes am Nebenschlusswiderstand kann der Strom des Leiters bestimmt werden. Das Gehäuse der Vorrichtung ist dreiteilig ausgebildet. Das obere Gehäuse umschließt den stromdurchflossenen Leiter und ist über ein isolierendes Stützrohr mit dem unteren Gehäuse verbunden. Das obere Gehäuse liegt auf Hochspannungspotential, während das untere Gehäuse auf Erdpotential liegt.

### BEZUGSZEICHEN

- 1: Hochspannungstransformator
- 2: Referenzspannungswandler
- 3: Referenzmesskabel
- 4: Referenzauswertegerät
- 5: Spannungswandler
- 6: Messkabel
- 7: Auswertegerät
- 8: Hochstromtransformator
- 9: Referenzstromwandler
- 10: Referenzmesskabel
- 11: Referenzauswertegerät
- 12: Stromwandler
- 13: Messkabel
- 14: Auswertegerät
- 30: Container
- 31: Hochspannungstransformator
- 32: Referenzspannungswandler
- 33: Hochstromkreis
- 34: Hochstromtransformator
- 35: Referenzstromwandler
- 36: Referenzauswertegerät
- 37.1 und 37.2: Referenzmesskabel
- 38: Spannungswandler
- 39: Stromwandler
- 40: Auswertegerät
- 41.1 und 41.2: Messkabel
- 42: Bedienraum
- 43: Türe
- 44: verlängerbare Hochstromverbindung
- 45: Datenverbindungsleitung

## Patentansprüche

1. Vorrichtung zum Kalibrieren eines Leistungsmesssystems für Leistungstransformatoren, umfassend
- einen Hochspannungstransformator (31),
- einen Referenzspannungswandler (32),
- einen Hochstromkreis (33),
- einen Hochstromtransformator (34),
- einen Referenzstromwandler (35),
- ein Referenzauswertegerät (36),
- Referenzmesskabel (37.1, 37.2),
- einen Container (30),
wobei
- das Leistungsmesssystem einen Spannungswandler (38), einen Stromwandler (39) und ein Auswertegerät (40) umfasst;
- der Hochspannungstransformator (31) die erforderliche Kalibrierspannung zur Verfügung stellt;
- der Referenzspannungswandler (32) mit dem Hochspannungstransformator (31) elektrisch verbunden ist und mittels des Hochstromkreises (33) sowohl mit dem Hochstromtransformator (34), als auch dem Referenzstromwandler (35) in elektrischer Verbindung steht;
- das Referenzauswertegerät (36) jeweils über die Referenzmesskabel (37.1, 37.2) sowohl mit dem Referenzspannungswandler (32) als auch dem Referenzstromwandler (35) elektrisch verbunden ist;
- der Hochspannungstransformator (31), der Referenzspannungswandler (32), der Hochstromkreis (33), der Hochstromtransformator (34), der Referenzstromwandler (35), das Referenzauswertegerät (36) und die Referenzmesskabel (37.1, 37.2) innerhalb des Containers (30) angeordnet sind;
- die zu kalibrierenden Teilkomponenten des Leistungsmesssystems, nämlich der Spannungswandler (38), der Stromwandler (39) und das Auswertegerät (40), mit dem Hochstromkreis (33) elektrisch derart in Wirkverbindung stehen, dass damit eine Vor-Ort-Kalibrierung des Leistungsmesssystems als Systemkalibrierung durchführbar ist;
**dadurch gekennzeichnet, dass**
- der Spannungswandler (38) in den Hochstromkreis (33) eingeschleift ist.

2. Vorrichtung nach dem vorigen Anspruch, wobei das Auswertegerät (40) jeweils über Messkabel (41.1, 41.2) sowohl mit dem Spannungswandler (38) als auch dem Stromwandler (39) elektrisch in Verbindung steht.

3. Vorrichtung nach Anspruch 1 oder 2, wobei der Spannungswandler (38), der Stromwandler (39) und das Auswertegerät (40) innerhalb des Containers (30) angeordnet sind.

4. Vorrichtung nach Anspruch 1 oder 2, wobei der Spannungswandler (38), der Stromwandler (39) und das Auswertegerät (40) außerhalb des Containers (30) angeordnet sind.

5. Vorrichtung nach dem vorigen Anspruch, wobei
- der Spannungswandler (38) und der Stromwandler (39) mittels einer verlängerbaren Hochstromverbindung (44) in den Hochstromkreis (33) elektrisch eingeschleift sind und
- das Auswertegerät (40) mittels einer Datenverbindung (45) mit dem Referenzauswertegerät (36) kommuniziert.

6. Vorrichtung nach einem der vorigen Ansprüche, wobei der Referenzspannungswandler (32) und der zu kalibrierende Spannungswandler (38) als kapazitive Spannungswandler ausgebildet sind.

7. Vorrichtung nach einem der vorigen Ansprüche, wobei der Referenzstromwandler (35) und der zu kalibrierende Stromwandler (39) als induktive Stromwandler ausgebildet sind.

8. Vorrichtung nach einem der vorigen Ansprüche, wobei mittels des Hochspannungstransformators (31) eine Kalibrierspannung von 100 kV und mehr generierbar ist.

9. Vorrichtung nach einem der vorigen Ansprüche, wobei mittels des Hochstromtransformators (34) ein maximaler Prüfstrom von einigen kA erzeugbar ist.

10. Vorrichtung nach einem der vorigen Ansprüche, wobei das Referenzauswertegerät (36) und das Auswertegerät (40) die entsprechende Wirkleistung, die Scheinleistung, die Frequenz und den Phasenwinkel zwischen jeweils angelegtem Strom und angelegter Spannung ermitteln.

11. Vorrichtung nach einem der vorigen Ansprüche, wobei
- innerhalb des Containers (30) ein separater, elektromagnetisch abgeschirmter Bedienraum (42) vorgesehen ist und
- innerhalb des Bedienraums (42) mindestens die Auswerteeinheit (36) angeordnet ist.

12. Vorrichtung nach einem der vorigen Ansprüche, wobei der Container (30) äußere Standardabmessungen aufweist.

## Claims

1. An apparatus for calibrating a power measurement system for power transformers, said apparatus comprising
- a high-voltage transformer (31),
- a reference voltage transformer (32),
- a high-current circuit (33),
- a high-current transformer (34),
- a reference current transformer (35),
- a reference evaluation device (36),
- reference measuring cables (37.1, 37.2),
- a container (30);
wherein
- the power measurement system comprises a voltage transformer (38), a current transformer (39), and an evaluation device (40);
- the high-voltage transformer (31) supplies the required calibrating voltage;
- the reference voltage transformer (32) is electrically connected to the high-voltage transformer (31) and is in electrical connection both to the high-current transformer (34) and to the reference current transformer (35) by means of the high-current circuit (33);
- the reference evaluation device (36) is electrically connected both to the reference voltage transformer (32) and to the reference current transformer (35), in each case via the reference measuring cables (37.1, 37.2);
- the high-voltage transformer (31), the reference voltage transformer (32), the high-current circuit (33), the high-current transformer (34), the reference current transformer (35), the reference evaluation device (36), and the reference measuring cables (37.1, 37.2) are disposed within the container (30);
- the sub-components of the power measurement system that are to be calibrated, particularly the voltage transformer (38), the current transformer (39), and the evaluation device (40) are in an electrically operative connection to the high-current circuit (33) in such a manner that an on-site calibration on the power measurement system is performable therewith by way of system calibration;
**characterised in that** the voltage transformer (38) is looped into the high-current circuit (33).

2. The apparatus according to the previous claim, wherein the evaluation device (40) is electrically in connection both to the voltage transformer (38) and to the current transformer (39), in each case via measuring cables (41.1, 41.2).

3. The apparatus according to claim 1 or 2, wherein the voltage transformer (38), the current transformer (39), and the evaluation device (40) are disposed within the container (30).

4. The apparatus according to claim 1 or 2, wherein the voltage transformer (38), the current transformer (39), and the evaluation device (40) are disposed outside of the container (30).

5. The apparatus according to the previous claim, wherein
- the voltage transformer (38) and the current transformer (39) are electrically looped into the high-current circuit (33) by means of an extendable high-current connection (44), and
- the evaluation device (40) communicates with the reference evaluation device (36) by means of a data connection (45).

6. The apparatus according to one of the previous claims, wherein the reference voltage transformer (32) and the voltage transformer (38) to be calibrated are constructed as capacitive voltage transformers.

7. The apparatus according to one of the previous claims, wherein the reference current transformer (35) and the current transformer (39) to be calibrated are constructed as inductive current transformers.

8. The apparatus according to one of the previous claims, wherein a calibrating voltage of 100 kV and higher is generatable by means of the high-voltage transformer (31).

9. The apparatus according to one of the previous claims, wherein a maximum test current of several kA is generatable by means of the high-current transformer (34).

10. The apparatus according to one of the previous claims, wherein the reference evaluation device (36) and the evaluation device (40) determine the corresponding active power, the apparent power, the frequency, and the phase angle, in each case between applied current and applied voltage.

11. The apparatus according to one of the previous claims, wherein
- a separate, electromagnetically shielded control room (42) is provided within the container (30), and
- at least the evaluation unit (36) is disposed within the control room (42).

12. The apparatus according to one of the previous claims, wherein the container (30) has standard external dimensions.

## Revendications

1. Dispositif permettant de calibrer un système de mesure de puissance destiné à des transformateurs de puissance comprenant :
- un transformateur haute tension (31),
- un convertisseur de tension de référence (32),
- un circuit haute intensité (33),
- un transformateur haute intensité (34),
- un convertisseur d'intensité de référence (35),
- un appareil d'exploitation de référence (36),
- un câble de mesure de référence (37.1, 37.2),
- un réceptacle (30),
dans lequel :
- le système de mesure de puissance comprend un convertisseur de tension (38), un convertisseur d'intensité (39) et un appareil d'exploitation (40),
- le transformateur haute tension (31) fournit la tension de calibrage nécessaire,
- le convertisseur de tension de référence (32) est relié électriquement au transformateur haute tension (31) et est en liaison électrique, par l'intermédiaire du circuit haute intensité (33) avec le transformateur haute intensité (34) et également avec le convertisseur d'intensité de référence (35),
- l'appareil d'exploitation de référence (36) est respectivement relié électriquement par l'intermédiaire du câble de mesure de référence (37.1, 37.2) avec le convertisseur de tension de référence (32) et également avec le convertisseur d'intensité de référence (35),
- le transformateur haute-tension (31), le convertisseur de tension de référence (32), le circuit haute intensité (33), le transformateur haute intensité (34), le convertisseur d'intensité de référence (35), l'appareil d'exploitation de référence (36) et le câble de mesure de référence (37.1, 37.2) sont montés à la partie interne du réceptacle (30),
- les composants partiels à calibrer du système de mesure de puissance, à savoir le convertisseur de tension (38), le convertisseur d'intensité (39) et l'appareil d'exploitation (40) sont en liaison électrique fonctionnelle avec le circuit haute intensité (33) de façon à permettre d'effectuer ainsi un calibrage in situ du système de mesure de puissance sous la forme d'un calibrage systémique,
**caractérisé en ce que**
le convertisseur de tension (38) est bouclé dans le circuit haute intensité (33).

2. Dispositif conforme à la revendication précédente, dans lequel l'appareil d'exploitation (40) est respectivement en liaison électrique par l'intermédiaire du câble de mesure (41.1, 41.2) avec le convertisseur de tension (38) et également avec le convertisseur d'intensité (39).

3. Dispositif conforme à la revendication 1 ou 2, dans lequel le convertisseur de tension (38), le convertisseur d'intensité (39) et l'appareil d'exploitation (40) sont montés à la partie interne du réceptacle (30).

4. Dispositif conforme à la revendication 1 ou 2, dans lequel le convertisseur de tension (38), le convertisseur d'intensité (39) et l'appareil d'exploitation (40) sont montés à la partie interne du réceptacle (30).

5. Dispositif conforme à la revendication précédente, dans lequel :
- le convertisseur de tension (38) et le convertisseur d'intensité (39) sont bouclés électriquement dans le circuit haute intensité (33) au moyen d'une liaison haute intensité pouvant être prolongée (44), et
- l'appareil d'exploitation (40) est en communication avec l'appareil d'exploitation de référence (36) par l'intermédiaire d'une liaison de données (45).

6. Dispositif conforme à l'une des revendications précédentes, dans lequel le convertisseur de tension de référence (32) et le convertisseur de tension à calibrer (38) sont réalisés sous la forme d'un convertisseur de tension capacitif.

7. Dispositif conforme à l'une des revendications précédentes,
dans lequel le convertisseur d'intensité de référence (35) et le convertisseur d'intensité à calibrer (39) sont réalisés sous la forme de convertisseurs d'intensité inductifs.

8. Dispositif conforme à l'une des revendications précédentes, **caractérisé en ce que**
le transformateur haute tension (31) permet de générer une tension de calibrage de 100 kV et plus.

9. Dispositif conforme à l'une des revendications précédentes,
dans lequel le transformateur haute intensité (34) permet d'obtenir une intensité de contrôle maximum de quelques kA.

10. Dispositif conforme à l'une des revendications précédentes,
dans lequel l'appareil d'exploitation de référence (36) et l'appareil d'exploitation (40) déterminent la puissance active correspondante, la puissance apparente, la fréquence et le déphasage entre l'intensité appliquée et la tension appliquée respectives.

11. Dispositif conforme à l'une des revendications précédentes,
- dans lequel il est prévu, à la partie interne du réceptacle (30) un volume de commande (42) séparé protégé vis-à-vis des influences électro-magnétiques, et
- à la partie interne du volume de commande (42) est montée au moins l'unité d'exploitation (36).

12. Dispositif conforme à l'une des revendications précédentes, dans lequel le réceptacle (30) a des dimensions externes standard.
